# EUROPEAN PATENT APPLICATION

(11) **EP 4 258 360 A1**
(43) Date of publication of application: **11.10.2023**
(21) Application number: 22166501.1
(22) Date of filing: 04.04.2022
(51) Int. Cl.: H01L 29/06, H01L 29/08, H01L 29/10, H01L 29/40, H01L 29/66, H01L 29/739, H01L 29/78

(54) **METHOD FOR PRODUCING A SEMICONDUCTOR DEVICE AND SEMICONDUCTOR DEVICE**

(71) Applicant: Hitachi Energy Switzerland AG, 5400 Baden (CH)
(72) Inventor: BELLINI, Marco, 8005 Zürich (CH); BUITRAGO, Elizabeth, 5210 Windisch (CH); VITALE, Wolfgang Amadeus, 5000 Aarau (CH)
(74) Representative: Epping - Hermann - Fischer

(57) **Abstract**

A method for producing a semiconductor device (100) comprises a step of providing a semiconductor body (1) with a mask (3) on the top side (10) of the semiconductor body. A first and a second trench (2) extend from the top side into the semiconductor body. A functional portion (11) is arranged between the trenches. The mask comprises two first sections (31) and a second section (32). In the first sections, the mask is thicker than in the second section. In plan view of the top side, the second section overlaps with the functional portion and the first sections each overlap with one of the trenches. In a further step, a first region (12) of a first conductivity type is formed in the functional portion directly adjacent to the first trench. This comprises implanting first-type dopants into the functional portion by using a directed implantation method in which the implantation is done with an implant angle α greater than 0°. In a further step, a second region (13) of a second conductivity type is formed in the functional portion directly adjacent to the second trench. This comprises implanting second-type dopants into the functional portion by using a directed implantation method in which the implantation is done with an implant angle α smaller than 0°.

## Description

The present disclosure relates to a method for producing a semiconductor device and a semiconductor device.

There is a need for an improved method for producing a semiconductor device, e.g. for a method with a low number of method steps and/or for a method which allows the production of small structures. Furthermore, there is a need for an improved semiconductor device, e.g. for a semiconductor device with small structures.

Embodiments of the disclosure relate to an improved method for producing a semiconductor device. Other embodiments relate to an improved semiconductor device.

First, the method for producing a semiconductor device is specified.

According to an embodiment, the method for producing a semiconductor device comprises a step of providing a semiconductor body with a mask on the top side of the semiconductor body. At least one first and one second trench laterally spaced from each other extend from the top side into the semiconductor body. A functional portion of the semiconductor body is arranged laterally between the first and the second trench. The mask comprises at least two first sections and at least one second section laterally between the first sections. In the first sections, the mask is thicker than in the second section. In plan view of the top side, the second section overlaps with the functional portion and the first sections each overlap with one of the trenches. The method further comprises a step in which a first region of a first conductivity type is formed in the functional portion adjacent to the first trench. Forming the first region comprises implanting first-type dopants through the top side into the functional portion by using a directed implantation method in which the implantation is done with an implant angle α greater than 0°. The method further comprises a step of forming a second region of a second conductivity type in the functional portion adjacent to the second trench. Forming the second region comprises implanting second-type dopants through the top side into the functional portion by using a directed implantation method in which the implantation is done with an implant angle α smaller than 0°.

With this method, only one lithography step is needed to pattern two regions of different conductivity type and formed laterally next to each other with well-defined sizes and locations. These regions are, e.g., contacted to a source or emitter electrode and form part of a power semiconductor device/switch, like an IGBT or MOSFET.

The semiconductor body may comprise or may consist of Si or SiC. The top side of the semiconductor body may run parallel to a main extension plane of the semiconductor body. A lateral direction is herein defined as a direction parallel to the top side and/or parallel to the main extension plane of the semiconductor body. A vertical direction is herein defined as a direction perpendicular to the top side and/or to the main extension plane of the semiconductor body.

More than two trenches may extend from the top side into the semiconductor body. For example, the semiconductor device comprises a plurality of pairs of a first and a second trench, each pair sandwiching a functional portion. All features disclosed here and in the following for one trench or one pair of a first and a second trench are also disclosed for all other trenches or pairs, respectively, of the semiconductor device. For instance, each trench may overlap with a first section of the mask.

For example, the at least one trench has a depth, measured in vertical direction, of at least 1 µm and at most 10 µm or at least 3 µm and at most 7 µm. The maximum width of the trench, measured in lateral direction, may be at most 3 µm or at most 1 µm. For instance, the width of the trench is smaller than its depth. The trench may taper in vertical direction from the top side into the semiconductor body.

The functional portion is a portion of the semiconductor body provided for an electrical functionality of the final semiconductor device. For example, during operation of the semiconductor device, electrons or holes are transported through the functional portion, e.g. in vertical direction. The functional portion forms part of the top side and, starting from the top side, extends into the interior of the semiconductor body. The functional portion laterally extends between the first trench and the second trench.

The mask may be formed of a semiconductor material and/or an insulating material. For example, the mask comprises or consists of Si or SiO₂.

The mask comprises at least two first sections and at least one second section, wherein the at least one second section is located laterally between the two first sections. In plan view of the top side, i.e. in top view of the top side, the two first sections of the mask each overlap with either the first or the second trench. This means that in plan view of the top side, the first sections partially or completely overlap with the respective trench. For example, the first sections of the mask only partially overlap with the respective trench so that a portion of each trench adjacent to the functional portion projects beyond the respective first section of the mask in lateral direction and towards the functional portion. In other words, in each case, a step between the first section of the mask and the second section of the mask may be formed in the region of the trench, i.e. the step may overlap with the trench in plan view of the top side.

In plan view of the top side, the second section of the mask overlaps with the functional portion at least partially. For example, the second section completely overlaps the functional portion. The second section may partially overlap with the first and/or the second trench.

The second section of the mask is thinner than the first sections of the mask For example, the first sections are each at least 2-times or at least 3-times or at least 5-times as thick as the second section. In the first sections of the mask, the thickness may be at most 2 µm and/or at least 0.5 µm. In the second section of the mask, the thickness may even be zero so that the top side of the semiconductor body is exposed in the second section. Thus, the second section of the mask may be a hole or recess in the mask. The thicknesses of the mask are herein measured in vertical direction. Everything on the top side during the implantation of the first-type dopants and the second-type dopants may be considered as being part of the mask.

The first sections may all have the same thickness. Alternatively, the first section overlapping with the first trench may have a different thickness than the first section overlapping with the second trench. The thickness difference is at least 0.5 µm, for example.

The first region may be formed directly under the top side, i.e. the first region may adjoin the top side. The first region may further be formed such that it adjoins the first trench. For forming the first region, the first-type dopants may first be implanted and may thereby accumulate at the top side. Then, a drive process or annealing process, respectively, may be performed in which the first-type dopants further drift into the semiconductor body so that the first region expands. For example, the first region is finalized with the drive process. The second region of the second conductivity type may be produced correspondingly. Particularly, the formed second region may also adjoin the top side and/or the second trench.

The first conductivity type may be either electron conduction or hole conduction, i.e. the first region may be either n-doped or p-doped. The first-type dopants are, accordingly, n-type dopants or p-type dopants. The second conductivity type is the opposite conductivity type of the first conductivity type, i.e. either hole conduction or electron conduction. The second-type dopants are, accordingly, p-type dopants or n-type dopants. The first-type dopants are, e.g., As or P. The second-type dopants are, e.g. Boron (B).

A directed implantation method is used for implanting the first-type dopants and the second-type dopants. The implantation is in both cases done obliquely to the top side, i.e. with an implant angle unequal to 0°. Here and in the following, angles are, in particular, defined relative to the semiconductor body or its top side, respectively.

The implant angle of the implantation is defined as the angle between the main implantation direction and a normal or normal plane of the top side, respectively. The normal plane extends perpendicularly to the top side and, for example, along the first portion. For example, the implant angle for implanting the first-type dopants is between 10° and 80°, inclusive. The implant angle α for implanting the second-type dopants may be between -10° and -80° inclusive. It is clear that the sign of α is only a matter of definition. What matters here is that the sign of α is different for the implantation of the first- and the second-type dopants. For example, the implantation direction is mirrored at the normal plane.

There are different possibilities to realize the different implant angles. For example, a tilt angle of the beam being equal to the magnitude of the implant angle is set to hit the top side at an oblique angle and, when changing form implanting the first-type dopants to implanting the second-type dopants, the semiconductor body (wafer) is rotated by a twist angle of, e.g. 180°, without changing the tilt angle. Alternatively the tilt angle (implant angle) may be changed when changing from implanting the first-type dopants to implanting the second-type dopants without changing the twist angle. Also a combination in which the tilt angle and the twist angle are change may be used. The tilt angle may be the implant angle.

The consequence of the implantation with two different implant angles is that a certain region of the functional portion is shadowed by a first section of the mask. During implantation of the second-type dopants, the first section overlapping with the first trench shadows or protects, respectively, the region of the functional portion adjacent to the first trench so that the second-type dopants are mainly implanted in the region of the functional portion adjacent to the second trench. Accordingly, a negative implant angle α means that the main implantation direction has a lateral component pointing from the functional portion to the second trench. During implantation of the first-type dopants, the first section overlapping with the second trench shadows or protects, respectively, a region of the functional portion adjacent to the second trench so that the first-type dopants are mainly implanted in the region of the functional portion adjacent to the first trench. Accordingly, a positive implant angle α means that the main implantation direction has a lateral component pointing from the functional portion towards the first trench.

The order of implantation of the first-type dopants and the second-type dopants may be changed. For example, firstly, the first-type dopants and then the second-type dopants are implanted or vice versa. The above-mentioned drive process may be done simultaneously for the first-type dopants and the second-type dopants.

During implanting dopants, the implantation direction may change or oscillate, respectively. Thus, when speaking about an implantation direction or implant angle used for the implantation, an average implantation direction averaged over the whole duration of the implantation process is meant. Therefore, the first-type dopants are on average implanted with a positive implant angle and the second-type dopants are on average implanted with a negative implant angle. Accordingly, every implant angle mentioned here and in the following is an average implant angle.

According to a further embodiment, the first region is formed such that the first region adjoins the top side as well as the first trench and is laterally spaced from the second trench.

According to a further embodiment, the second region is formed such that the second region adjoins the top side as well as the second trench and is laterally spaced from the first trench.

The first region and the second region may each be contiguous without interruptions.

According to a further embodiment, the functional portion is elongated in a first lateral direction and, in a second lateral direction being perpendicular to the first lateral direction, is arranged between the first and the second trench. The trenches are, e.g., also elongated in the first lateral direction. The lengths of the functional portion and/or the trenches, measured in the first lateral direction, is, e.g., at least 5-times or at least 10-times the width of the functional portion and/or the trenches, measured in the second lateral direction. The normal plane may extend in the first lateral direction.

According to a further embodiment, several first regions are formed in the functional portion which are arranged one behind the other in the first lateral direction and are spaced from each other pairwise in the first lateral direction. All features disclosed herein in connection with one first region of the functional portion are also disclosed for all other first regions of the functional portion. All first regions of the functional portion may be produced simultaneously.

According to a further embodiment, several second regions are formed in the functional portion which are arranged one behind the other in the first lateral direction and are spaced from each other pairwise in the first lateral direction. All features disclosed herein in connection with one second region of the functional portion are also disclosed for all other second regions of the functional portion. All first regions of the functional portion may be produced simultaneously.

In order to form a plurality of first and/or second regions in the functional portion, the second section of the mask may have an alternating width, measured in the second lateral direction. Thus, regions of the second section of greater and smaller width are arranged in an alternating manner one behind the other in the first lateral direction.

The space in the first lateral direction, between each two first regions is, e.g., smaller than the length, measured in the first lateral direction, of each first region. For example, the length of each first region is between 1 µm and 12 µm, inclusive, or between 1 µm and 4 µm inclusive. For example, the border line at the top side adjoining the first trench and extending in the first lateral direction is formed to 60 % ± 10 % by first regions.

What is disclosed in the last paragraph with respect to the first regions is correspondingly also disclosed for the second regions.

The semiconductor device may be produced with two or more functional portions, each functional portion comprising at least one first region and at least one second region. All features disclosed so far and in the following for one functional portion are also disclosed for the other functional portions.

According to a further embodiment, the first sections of the mask are laterally offset with respect to the functional portion. In other words, the first sections do not overlap with the functional portion in plan view of the top side.

According to a further embodiment, the implant angle α is chosen to have an absolute value of |atan((D+W)/H)| ± 10° or ± 5°, i.e. with a maximum deviation of 10° or 5°. Herein, H is the thickness of the mask in the first section, W is the width of the functional portion at the top side measured in lateral direction (in the second lateral direction), i.e. the lateral distance between the two trenches, D is the distance in lateral direction (second lateral direction) between the transition, e.g. step, from a first section to the second section of the mask and the functional portion. In the case that the first section is retracted from the functional portion, D is positive. If the first section overlaps with the functional portion, D is negative. Herein, D is defined, e.g., as the shortest distance, in lateral direction, between the transition and the functional portion.

When implanting the first-type dopants, it is clear for the skilled person that D is meant to be the distance between the functional portion and the transition from the first section overlapping with the second trench to the second section. When implanting the second-type dopants, D is meant to be the distance between the functional portion and the transition from the first section overlapping with the first trench to the second section of the mask.

With such implant angles α, the highest implantation intensity of first-type dopants reaching the functional portion can be adjusted to be in the region close to the first trench of the functional portion and the highest implantation intensity of second-type dopants reaching the functional portion can be adjusted to be in the region close to the second trench of the functional portion. The rest of the functional portion is shaded by the first sections.

According to a further embodiment, before forming the first region and the second region, a third region of the second conductivity type is formed in the semiconductor body, particularly in the functional portion. The third region is, e.g., finalized when the mask is on the top side. Forming the third region comprises implanting second-type dopants through the top side into the semiconductor body. The second-type dopants for forming the third region may be of the same material as the ones for forming the second region, e.g. of B. Also here, after implantation, a drive process or an anneal process, respectively, may be performed. Implantation of second-type dopants for forming the third region may be done before and/or after forming the trenches in the semiconductor body. Implantation of second-type dopants for forming the third region may be done before and/or after forming the mask on the semiconductor body.

At least within the functional portion, the third region may be formed directly under the top side, i.e. adjoining the top side. A part of the third region may be converted into the first and/or second region later on.

According to a further embodiment, after forming the first region and the second region, a main electrode is applied onto the top side in order to electrically contact the semiconductor body in the region of the functional portion. Before applying the main electrode and after forming the first and second regions, an etch process may be performed in order to remove part of the mask, e.g. the second section of the mask. However, particularly in the region of the trenches, where the mask is at least partially formed by the first sections having a larger thickness, remnant structures of the mask may be preserved and may form part of the final semiconductor device.

The main electrode may be applied such that it is in direct electrical contact with the first region and/or with the second region. The main electrode may be formed of metal.

According to a further embodiment, the trenches are filled with an electrically conductive material. The electrically conductive material may be electrically isolated from the semiconductor body by an insulation layer applied on surfaces of the trenches. Particularly lateral surfaces of the trenches, which delimit the trenches in lateral direction, may be covered by the insulation layer in order to electrically isolate the functional portion from the conductive material. The conductive material is, e.g., highly-doped polysilicon, like n-type polysilicon. The insulation layer may be formed of SiO₂.

When providing the semiconductor body, i.e. before implanting the first-type dopants, the trenches may already be filled with the electrically conductive material and/or the insulation layer.

According to a further embodiment, the semiconductor device is an insulated gate transistor. For example, the semiconductor device is a MOSFET or an Insulated Gate Bipolar Transistor (IGBT). The main electrode may then be a source electrode or emitter electrode, respectively. The first region may be a source region or emitter region, respectively, of the semiconductor body. The second region may be a so-called RB-prime region. On the bottom side of the semiconductor body, opposite to the top side, a further main electrode may be applied which may constitute a drain electrode or collector electrode, respectively.

According to a further embodiment, the trench is part of the insulated gate. For example, the electrically conductive material in the trench is electrically connected to a gate electrode. The gate electrode may be applied on the top side. An insulation between the gate electrode and the semiconductor material of the functional portion may be realized by the insulation layer in the trench.

According to a further embodiment, in the step of providing the semiconductor body, the functional portion is of the second conductivity type, at least directly under the top side, i.e. adjacent to the top side. For example, an implantation process with second-type dopants has been performed beforehand so that this part of the functional portion is of the second conductivity type.

According to a further embodiment, the semiconductor body comprises at least one further functional portion laterally arranged between two trenches. The further functional portion may herein also be referred to as dummy functional portion or dummy channel portion or dummy mesa. The further functional portion is, for instance, spaced from the functional portion by at least one trench. For example, the functional portion and the further functional portion are separated from each other in lateral direction by exactly one trench.

According to a further embodiment, a maximum width of the further functional portion is different from a maximum width of the functional portion. For example, the further functional portion has a smaller maximum width than the functional portion. By way of example, a maximum width of the further functional portion is at most 80 % or at most 60 % of the maximum width of the functional portion.

According to a further embodiment, implanting the first-type dopants and/or the second-type dopants is done with such an implant angle α that the further functional portion is completely shaded by a first section of the mask. In other words, the further functional portion, i.e. the top side formed by the further functional portion, completely lies in the shadow of a first section. This first section of the mask may overlap with a trench adjacent to the further functional portion. For example, when performing the directed implantation processes for forming the first and the second regions, in each of these implantation processes, the further functional portion is completely shaded by a first section of the mask. In one implantation process, the further functional portion is then shaded by a first section on the trench on the left side of the further functional portion and, in the other implantation process, the further functional portion is shaded by a first section on the trench on the right side of the further functional portion.

The fact that the further functional portion is completely shaded by a first section of the mask does not mean that no first-type dopants or second-type dopants reach into the further functional portion since a portion of the first-type dopants or second-type dopants may, e.g., pass through the first section of the mask or may be implanted due to the random nature of the implantation process. Rather, "completely shaded" means that each straight line enclosing the angle α with a normal of the top side and passing through the top side in the area of the further functional portion runs at least partially through a first section of the mask. As a consequence of this, during implantation of the first-type dopants, the conductivity type in the further functional portion at the top side is, e.g., not changed.

Next, the semiconductor device is specified. The semiconductor device may, in particular, be produced with the method specified herein. Therefore, all features disclosed for the method are also disclosed for the semiconductor device and vice versa. The semiconductor device may be a semiconductor chip. The semiconductor device is, e.g., a power semiconductor device.

According to an embodiment, the semiconductor device comprises a semiconductor body having a top side. Further, the semiconductor device comprises at least one first trench and at least one second trench each extending from the top side into the semiconductor body. The first and the second trench are laterally spaced from each other. The semiconductor body comprises a functional portion which is arranged laterally between the first and the second trench. A first region of the functional portion is of a first conductivity type. The first region adjoins the top side, is arranged adjacent to the first trench and is laterally spaced from the second trench. A second region of the functional portion is of a second conductivity type. The second region adjoins the top side, is arranged adjacent to the second trench and is laterally spaced from the first trench.

For example, the first region adjoins the first trench. The first region may be laterally spaced from the second trench by the second region. The second region may adjoin the second trench. Furthermore, the second region may be laterally spaced from the first trench by the first region.

The first and/or the second region may have a maximum or average doping concentration which is at least one or two orders of magnitude greater than in the rest of the functional portion. For example, the maximum or average doping concentration in the first and/or the second region is at least 1·10¹⁷ cm⁻³ or at least 1·10¹⁸ cm⁻³ or at least 1·10¹⁹ cm⁻³. The doping concentration within the first and/or second region may be greatest at the top side.

According to a further embodiment, the width of the functional portion, e.g. the maximum width, measured in lateral direction (in second lateral direction) is at most 1.0 µm or at most 0.8 µm or at most 0.6 µm. The width may be measured at the top side.

The width of the first region and/or of the second region may be at most 500 nm or at most 400 nm or at most 300 nm. For example, the ratio of the depth of the trenches to the width of the functional portion is at least 3:1.

Due to the use of only first regions of a first conductivity type on one side of the trench and only second regions of a second conductivity type on the other side of the functional portion, the width of the functional portion can be chosen to be small which reduces, e.g., static losses. Such a narrow functional portion with a first and a second region can be produced with the help of the method described herein. Indeed, particularly thanks to the reduction of masking and the associated alignment steps, the width of the functional portion can be chosen to be very small. In this way alignment requirements are kept at a minimum for a given lithography technology.

According to a further embodiment, a remnant structure of a mask is arranged on the top side and overlaps with at least one trench in plan view of the top side. This is an indication that the herein specified method has been used to produce the semiconductor device.

There may be a plurality of remnant structures of the mask distributed over the top side. For example, a remnant structure of the mask is arranged on several trenches or on each trench. All remnant structures may have the same thickness within the limits of the manufacturing tolerance. The remnant structures may be free of any functionality in the semiconductor device. For example, the remnant structures comprise traces of a material removal, like an etch process. The remnant structures may comprise or consist of a semiconductor material, like Si or SiC, or of an insulator, like SiO₂. The remnant structure(s) may be vestigial structure(s).

According to a further embodiment, the remnant structure of the mask is a Si-structure, i.e. consists of Si.

According to a further embodiment, the trenches are filled with an electrically conductive material which is electrically isolated from the semiconductor body by an insulation layer applied on surfaces of the trenches. The insulation layer may be grown oxide.

According to a further embodiment, a main electrode is on the top side and in electrical contact with the functional portion, particularly in electrical contact with the first region and/or the second region of the functional portion.

According to a further embodiment, a gate electrode is arranged on the top side and in electrical contact with the electrically conductive material in at least the first trench. The gate electrode may be in electrical contact with the electrically conductive material in the first and the second trench. On the bottom side of the semiconductor body, opposite to the top side, a further main electrode may be arranged and may be in electrical contact with the semiconductor body.

Hereinafter, the method for producing a semiconductor device and the semiconductor device will be explained in more detail with reference to drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figure 1 shows a flowchart of an exemplary embodiment of the method for producing a semiconductor device,
Figures 2 to 17 and 19 show different positions in an exemplary embodiment of the method for producing a semiconductor device,
Figures 18 and 20 shows an exemplary embodiment of the semiconductor device,
Figure 21 shows a position in a further exemplary embodiment of the method for producing a semiconductor device, and
Figure 22 shows a further exemplary embodiment of the semiconductor device.

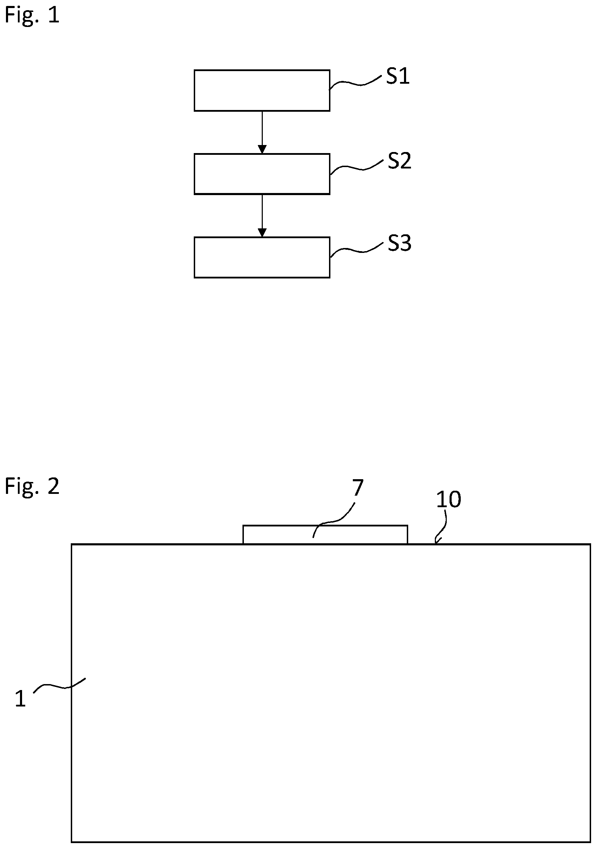

Figure 1 shows a flowchart of an exemplary embodiment of the method for producing a semiconductor device. In a step S1, a semiconductor body with a mask on a top side of the semiconductor body is provided. At least one first trench and at least one second trench, which are laterally spaced from each other, extend from the top side into the semiconductor body. A functional portion of the semiconductor body is arranged laterally between the first and the second trench. The mask comprises at least two first sections and at least one second section laterally between the first sections, wherein, in the first sections, the mask is thicker than in the second section. In plan view of the top side, the second section overlaps with the functional portion and the first sections each overlap with one of the trenches. In a step S2, a first region of a first conductivity type is formed in the functional portion adjacent to the first trench. Forming the first region comprises implanting first-type dopants through the top side into the functional portion by using a directed implantation method in which the implantation is done with an implant angle α greater than 0°. In a step S3, a second region of a second conductivity type is formed in the functional portion adjacent to the second trench. Forming the second region comprises implanting second-type dopants through the top side into the functional portion by using a directed implantation method in which the implantation is done with an implant angle α smaller than 0°.

In contrast to what is shown in figure 1, step S3 could also be performed before step S2.

In figure 2, a position of an exemplary embodiment of the method is shown in which a semiconductor body 1 is provided.

The semiconductor body 1 has a top side 10 parallel to a main extension plane of the semiconductor body 1. For example, the semiconductor body 1 consists of Si or SiC. The semiconductor body 1 may be slightly doped so that it is of a first conductivity type. In the following, as an example, the first conductivity type is assumed to be electron conduction and the according doping is n-type doping. Hence, the semiconductor body 1 is slightly n-doped. On the top side 10, a mask 7, e.g. of a photoresist, is formed. The structure of the mask 7 is, e.g., generated with help of photolithography.

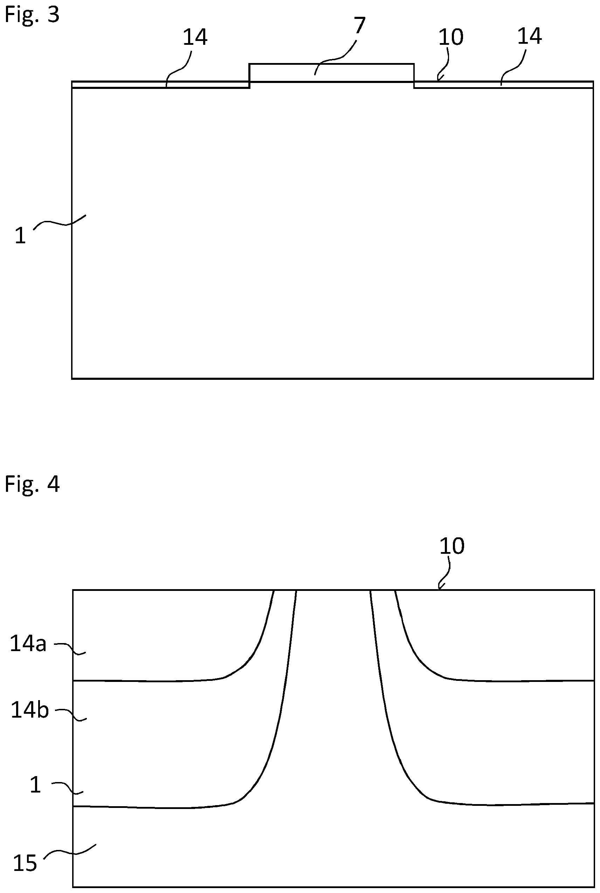

In the position of figure 3, an implantation process has been performed in which second-type dopants in the form of p-type dopants, e.g. Boron, have been implanted through the top side 10 into the semiconductor body 1. The second-type dopants have accumulated in the region directly under the top side 10 and have formed a p-doped region 14 (herein called third region 14). In figure 3, the doping concentration in the third region 14 is, e.g., approximately 1·10¹⁹ cm⁻³. The third region 14 is predominately or only formed in the regions uncovered by the mask 7.

Figure 4 shows a position after a drive process or annealing process, respectively, has been performed by which the second-type dopants have further drifted into the semiconductor body 1. Thereby, the p-doped third region 14 has expanded into the semiconductor body 1 so that two laterally spaced p-wells have formed. In figure 4, the doping profile of the third region 14 is illustrated with the help of two sections 14a, 14b with different doping concentrations. Section 14a has a greater doping concentration than section 14b. For instance, section 14a has a doping concentration of between approximately 8.3·10¹⁶ cm⁻³ and approximately 1.7·10¹⁸ cm⁻³ and section 14b has a doping concentration of between approximately 2.1·10¹⁴ cm⁻³ and approximately 8.3·10¹⁶ cm⁻³. In reality, the doping concentration may gradually increase from the lower part of section 14b to the upper part of section 14a.

A fourth region 15 of the semiconductor body 1 remains n-doped, i.e., during the drive process this region of the originally n-doped semiconductor body 1 is not converted into a p-doped region. For example, the doping concentration in the fourth region 15 is approximately 1·10¹³ cm⁻³.

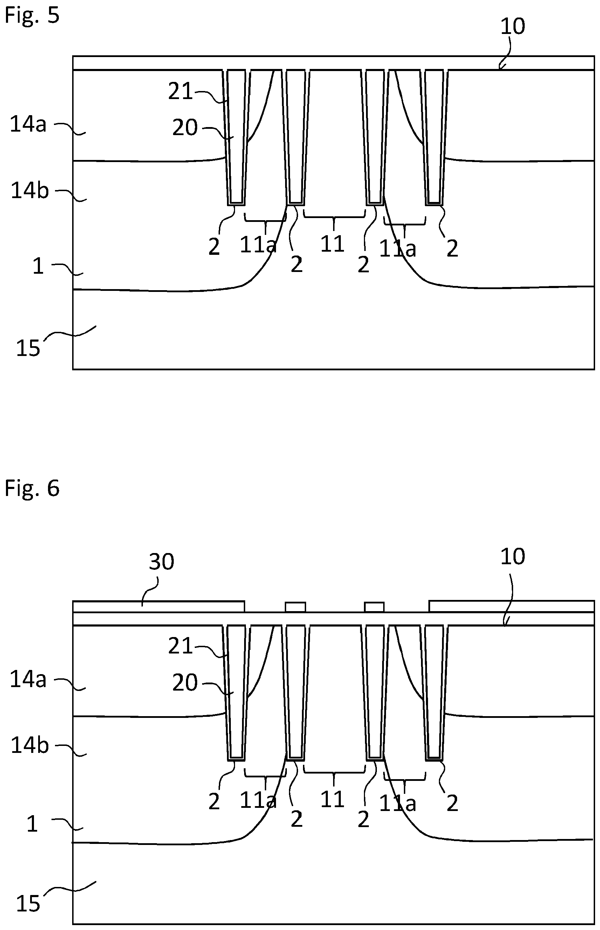

Figure 5 shows a position in the method in which a plurality of trenches 2 is introduced into the semiconductor body 1. Each trench 2 extends from the top side 10 into the semiconductor body 1 and thereby tapers in the direction from the top side 10 into the interior of the semiconductor body 1. The surfaces of the trenches 2 are covered with an electrical insulation layer 21, which also covers the top side 10 of the semiconductor body 1. The insulation layer 21 is, e.g., formed of SiO₂. Furthermore, the trenches 2 are filled with an electrically conductive material 20, e.g. highly-doped polysilicon.

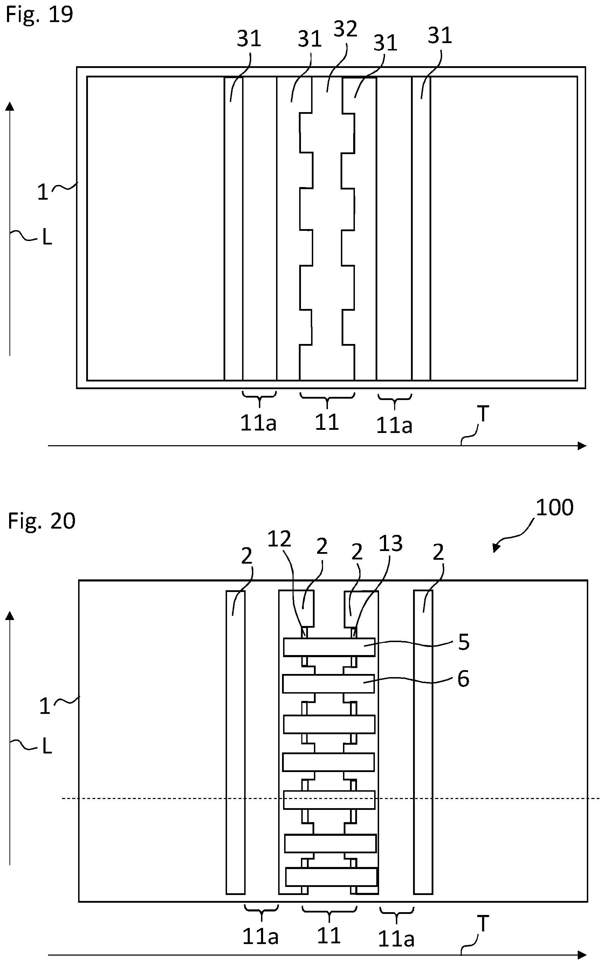

Functional portions 11, 11a, also called channel portions or mesas, are formed laterally between each pair of trenches 2. The functional portion 11 between the two inner trenches 2 is herein referred to as functional portion 11, whereas the functional portions 11a on the left and right side of the functional portion 11 are herein referred to as further functional portions 11a or dummy functional portions 11a, respectively. The trench 2 on the left side of the functional portion 11 adjoining the functional portion 11 is herein called first trench 2. The trench 2 on the right side of the functional portion 11 and adjoining the functional portion 11 is herein called second trench 2. The maximum width of the functional portion 11 is greater than the maximum width of the dummy functional portions 11a (see also figure 19, showing the semiconductor body 1 in plan view of the top side 10).

In figure 6 an auxiliary mask 30, e.g. of a photoresist, is formed on the top side 10 of the semiconductor body 1. Structuring of the auxiliary mask 30 has been done, for instance, with the help of a photolithography process. The structuring has been done such that in the regions overlapping with the functional portions 11, 11a, the photoresist 30 is completely removed so that the insulation layer 21 is exposed. The photoresist 30 is, on the other hand, not completely removed in the regions overlapping with the trenches 2.

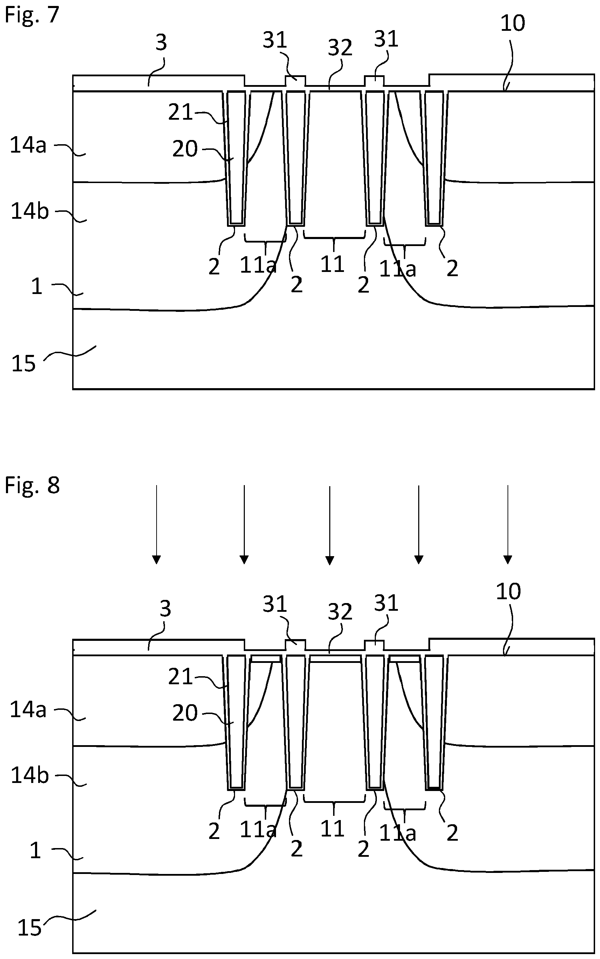

Figure 7 shows a position in which an etching process has been performed. In this etching process, the insulation layer 21 in the regions overlapping with the functional portions 11, 11a has been etched more strongly than in in the regions protected by the photoresist 30. In this way, a mask 3 of the material of the insulation layer 21 has been formed. The mask 3 comprises first sections 31 overlapping with the trenches 2 and second sections 32 overlapping with the functional portions 11, 11a. In the first sections 31, the mask 3 is thicker than in the second sections 32.

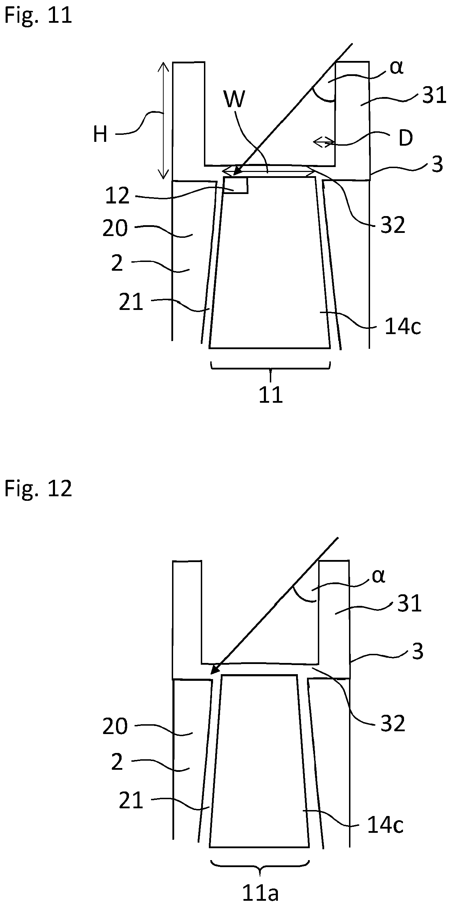

Figures 11 and 12 show detail views of the functional portions 11, 11a. Here it can be seen that the steps between the first sections 31 and the second sections 32 are retracted with respect to the lateral surfaces of the trenches 2 in the direction towards the trenches 2. Thus, the second section 32 extends over the whole functional portion 11, 11a and partially overlaps with the trenches 2.

In the position shown in figure 8, again second-type dopants are implanted through the top side 10 of the semiconductor body 1 into the functional portions 11, 11a. The second-type dopants may again be p-type dopants, e.g. Boron. The p-doping concentration under the top-side 10 is increased in the region of the functional portions 11, 11a. The implantation is done with a directed implantation method with a main implantation direction perpendicular to the top side.

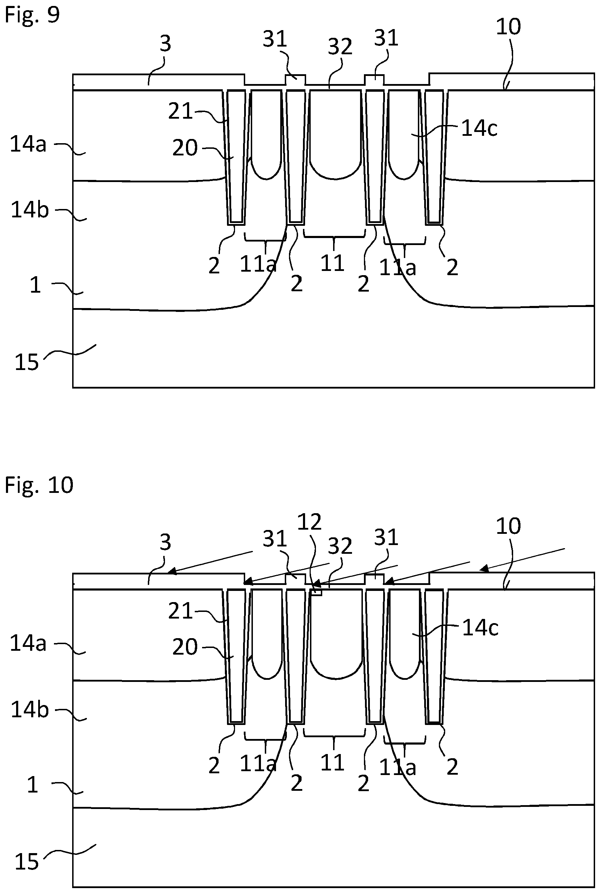

Figure 9 shows a position after a drive process in which the second-type dopants have further drifted into the semiconductor body 1 so that the doping profile of the p-doped third region 14 has changed. The doping profile is now illustrated using three sections 14a, 14b, 14c. The section 14c extends in the functional portions 11, 11a from the top side 10. The doping concentration is largest in the third section 14c, for example. The doping profile actually changes gradually from the first section 14a to the third section 14c.

In the position of figure 10, a method step is shown in which first-type dopants are implanted through the top side 10 into the functional portions 11, 11a. The first-type dopants are, in this case, n-type dopants, e.g. As or P. For implanting the first-type dopants, a directed implantation method is used with a magnitude of the implant angle α being larger than 0°, e.g. larger than 45°. Due to this tilted implantation, a region of the functional portions 11, 11a is shaded by the first sections 31 of the mask 3. This is further illustrated in figures 11 and 12, in which the functional portion 11 and the dummy functional portion 11a are shown in greater detail.

As can be seen in figure 11, the implant angle α of the implantation is chosen to be approximately |atan((D+W)/H)|, e.g. |atan((D+W)/H)| ± 10°, with H being the thickness of the mask 3 in the first section 31, W being the width of the functional portion 11 at the top side 10 measured in lateral direction and D being the distance in lateral direction between the first section 31 of the mask 3 and the functional portion 11. Due to this implant angle α, a major area of the functional portion 11 is shaded by the first section 31 of the mask 3 and only a small area adjacent to the first trench 2 is not shaded.

In figure 12, the dummy functional portion 11a is shown in greater detail. Due to the smaller width of the dummy functional portion 11a compared to the functional portion 11, the complete area of the dummy functional portion 11a is shaded by the first section 31 of the mask 3.

As can be seen in figures 10 and 11, due to the tilted implantation an n-doped first region 12 is formed adjacent to the first trench 2. In the rest, the shading by the first section 31 is so efficient that no doping conversion appears, i.e. this rest of the functional portion 11 remains p-doped. Also no conversion appears in the dummy functional portions 11a, so that the dummy functional portions 11a remain p-doped at the top side 10.

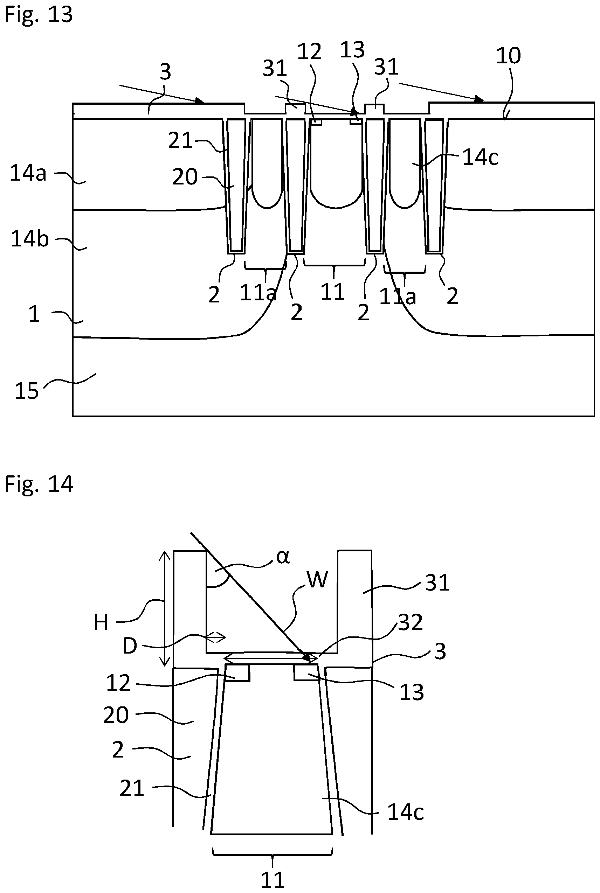

Figures 13 and 14 show a further method step in which second-type dopants are implanted with a directed implantation method, where the sign of the implant angle α has been reversed (e.g. the implantation direction has been mirrored) compared to what is shown in figures 10 to 12. Thereby, a p-doped second region 13 is formed in the functional portion 11 adjacent to the second trench 2. The rest of the functional portion 11 is efficiently shaded by a first section 31 of the mask 3. Also the dummy functional portions 11a are each shaded by a first section 31.

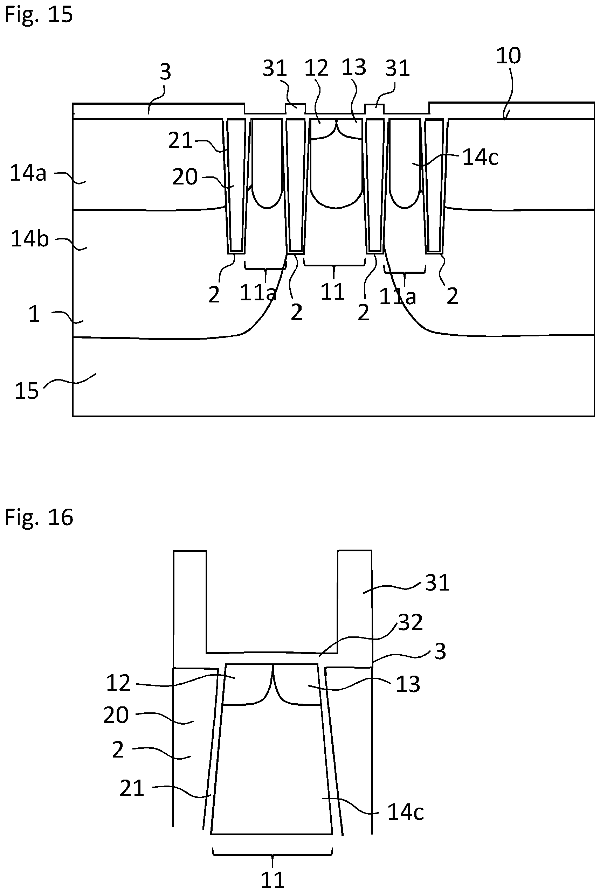

Figure 15 and 16 show a position after a drive process has been performed in which the first-type dopants and the second-type dopants have further drifted into the semiconductor body 1 and, consequently, the n-doped first region 12 and the p-doped second region 13 have expanded. Here, as an example, the first region 12 and the second region 14 adjoin each other.

The first region 12 adjoins the first trench 2 as well as the top side 10 and is laterally spaced from the second trench 2. The second region 13 adjoins the second trench 2 and the top side 10 and is laterally spaced from the first trench 2. For example, a maximum or average doping concentration in the first 12 and/or the second 13 region after the drive process is between 1·10¹⁵ cm⁻³ and 1·10¹⁷ cm⁻³.

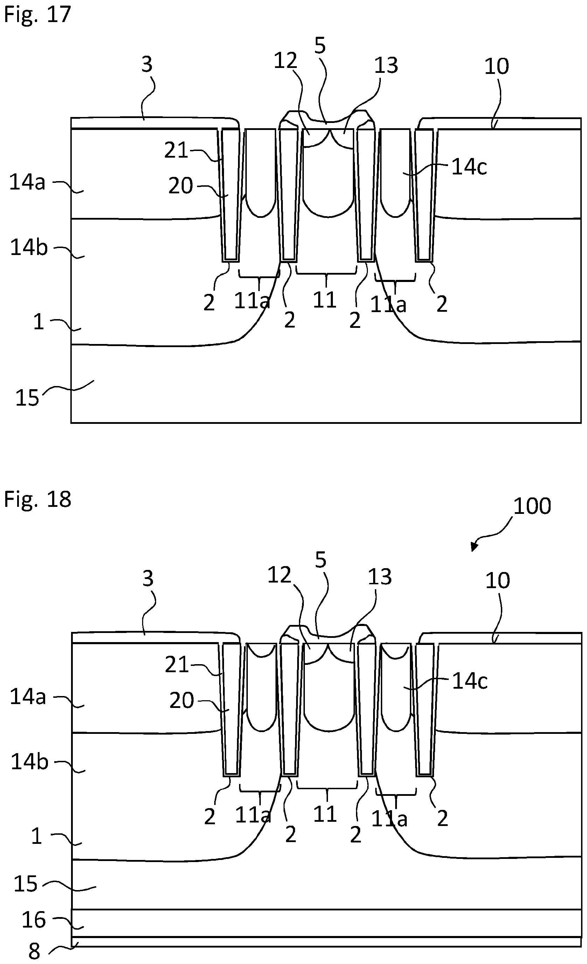

Figure 17 shows a further position in the method after the mask 3 has been etched so that in the regions of the second sections 32 the functional portions 11, 11a are exposed. Furthermore, a first main electrode 5, e.g. of metal, has been deposited onto the functional portion 11 so that the first main electrode 5 electrically contacts the first region 12 and the second region 13 of the functional portion 11. It can be further seen in figure 17 that remnants of the mask 3 are preserved in the region of the trenches 2. These remnants remain in the final semiconductor device.

Differently to what is shown in figure 17, the main electrode 5 may also contact the semiconductor body 1 in at least some regions of the dummy portions 11a.

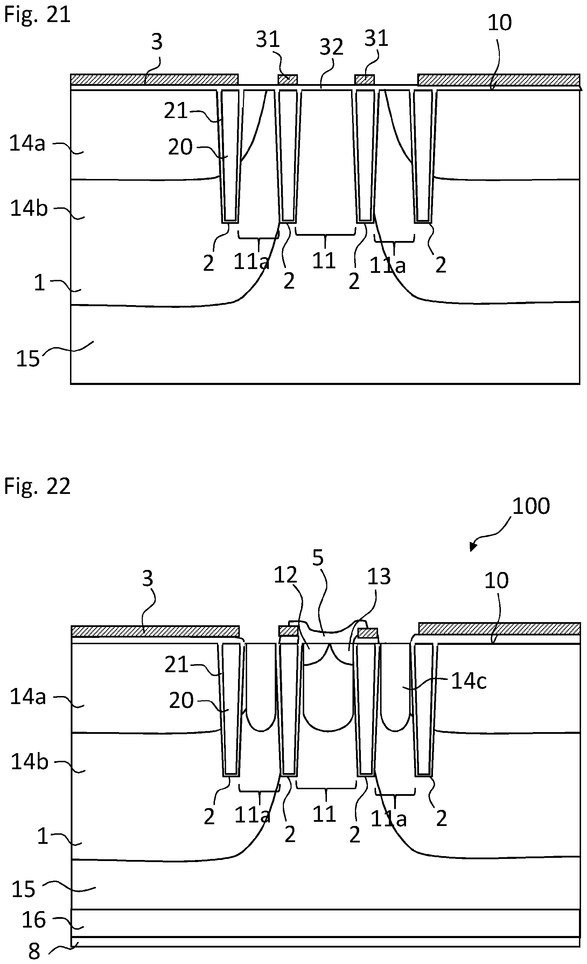

Figure 18 shows an exemplary embodiment of the semiconductor device 100 which is produced with the method described before. On the bottom side of the semiconductor body 1, opposite to the top side 10, a second main electrode 8 has been deposited. The second main electrode 8 is in direct electrical contact with a p-type fifth region 16 (collector layer or drain layer or anode layer) of the semiconductor body 1. The semiconductor device 100 shown in figure 22 is an IGBT.

Figure 20 shows the semiconductor device 100 of figure 18 in plan view of the top side 10 of the semiconductor body 1. As can be seen, the functional portion 11 comprises different sections with greater and smaller width, which alternate with each other along a first lateral direction L. The sections of the smaller width, wherein the width is measured in a second lateral direction T perpendicular to the first lateral direction L, are so narrow that in these sections neither n-doped first regions 12 nor p-doped second regions 13 were formed. This is similar to what happens to the dummy portions 11a. In these sections, gate electrodes 6 are applied which are electrically connected to the electrically conductive material 20 in the trenches 2. The dashed line in figure 20 indicates the cross-sectional plane for the representation of figure 18. The maximum width of the functional portion 11 is, e.g. 1.0 µm.

It should be emphasized that the configuration of figure 20 is indeed only one example. In a further exemplary embodiment, the alternating placement of the gate electrode 6 and the first main electrode 5 may be omitted and, instead, the first main electrode 5 is all over the top of the mask 3 and in direct contact with the functional portions 11, 11a wherever mask 3 is etched. The gate electrode 6 may then be in direct contact with the conductive material 20 in the trenches 2 only at the two longitudinal ends of the functional portions 11, 11a extending in the first lateral direction L.

The arrangement of figure 20 with a plurality of spaced first regions 12 within one functional portion has turned out to be beneficial in terms of current spreading during operation of the semiconductor device without loss of SCSOA capability. For example, 60 % ± 10 % of the top side 10 adjacent to the first trench 2 within the functional portion 11 is formed by the first regions 12.

In figure 19, the top side of the semiconductor body 1 is shown before the first-type dopants for forming the first regions 12 and before the second-type dopants for forming the second regions 13 are implanted. As can be seen, the mask 3 comprises first sections 31 and a second sections 32, wherein the second section 32 overlapping with the functional portion 11 has an alternating width.

Figure 21 shows a position in a second exemplary embodiment of the method. The shown position corresponds to the position shown in figure 7. In contrast to figure 7, the mask 3 is partially formed of silicon here. The insulation layer 21 of SiO₂ is arranged between the silicon (dashed areas) and the semiconductor body 1 and covers the top side 10.

Figure 22 shows the final semiconductor device 100 with remnant structures of the mask 3 comprising or consisting of Si. With the mask 3 being at least partially of Si, in order to expose the functional portion 11, 11a the etching process can be performed more precisely due to the different selectivities of Si and SiO₂.

The embodiments shown in the Figures 1 to 22 as stated represent exemplary embodiments of the improved method and the improved semiconductor device; therefore, they do not constitute a complete list of all embodiments according to the improved method and the improved semiconductor device. Actual semiconductor devices and methods may vary from the embodiments shown in terms of arrangements for example.

### Reference Signs

- 1: semiconductor body
- 2: trench
- 3: mask
- 5: first main electrode
- 6: gate electrode
- 7: mask
- 8: second main electrode
- 10: top side
- 11: functional portion
- 11a: further functional portion
- 12: first region
- 13: second region
- 14: third region
- 14a: section of third region
- 14b: section of third region
- 14c: section of third region
- 15: fourth region
- 16: fifth region
- 20: electrically conductive material
- 21: insulation layer
- 30: auxiliary mask
- 31: first section of mask 3
- 32: second section of mask 3
- 100: semiconductor device
- H: thickness
- W: width
- D: distance
- α: implant angle
- S1 to S3: method steps

## Claims

1. Method for producing a semiconductor device (100), comprising
- providing a semiconductor body (1) with a mask (3) on a top side (10) of the semiconductor body (1), wherein
- at least one first and one second trench (2) laterally spaced from each other extend from the top side (10) into the semiconductor body (1),
- a functional portion (11) of the semiconductor body (1) is arranged laterally between the first and the second trench (2),
- the mask (3) comprises at least two first sections (31) and at least one second section (32) laterally between the first sections (31), wherein, in the first sections (31), the mask (3) is thicker than in the second section (32),
- in plan view of the top side (10), the second section (32) overlaps with the functional portion (11) and the first sections (31) each overlap with one of the trenches (2);
- forming a first region (12) of a first conductivity type in the functional portion (11) adjacent to the first trench (2),
- comprising implanting first-type dopants through the top side (10) into the functional portion (11) by using a directed implantation method in which the implantation is done with an implant angle α greater than 0°;
- forming a second region (13) of a second conductivity type in the functional portion (11) adjacent to the second trench (2),
- comprising implanting second-type dopants through the top side (10) into the functional portion (11) by using a directed implantation method in which the implantation is done with an implant angle α smaller than 0°.

2. Method according to claim 1, wherein
- the first (12) and the second (13) region are formed such that
- the first region (12) adjoins the top side (10) as well as the first trench (2) and is laterally spaced from the second trench (2),
- the second region (13) adjoins the top side (10) and the second trench (2) and is laterally spaced from the first trench (2).

3. Method according to claim 1 or 2, wherein
- the functional portion (11) is elongated in a first lateral direction (L) and, in a second lateral direction (T) being perpendicular to the first lateral direction (L), is arranged between the first and the second trench (2),
- several first regions (12) are formed in the functional portion (11) which are arranged one behind the other in the first lateral direction (L) and are spaced from each other pairwise in the first lateral direction (L),
- several second regions (13) are formed in the functional portion (11) which are arranged one behind the other in the first lateral direction (L) and are spaced from each other pairwise in the first lateral direction (L).

4. Method according to any of the preceding claims, wherein
- the first sections (31) of the mask (3) are laterally offset with respect to the functional portion (11),
- the implant angle α is in each case chosen to have an absolute value of |atan((D+W)/H)| ± 10° with
- H being the thickness of the mask (3) in first section (31),
- W being the width of the functional portion (11) at the top side (10) measured in lateral direction,
- D being the distance in lateral direction between the transition from a first section (31) to the second section (32) of the mask (3) and the functional portion (11).

5. Method according to any one of the preceding claims, wherein
- before forming the first region (12) and the second region (13), a third region (14, 14c) of the second conductivity type is formed in the functional portion (11) under the top side (10), wherein forming the third region (14) comprises implanting second-type dopants through the top side (10) into the semiconductor body (1).

6. Method according to any one of the preceding claims,
- after forming the first region (12) and the second region (13), a main electrode (5) is applied onto the top side (10) in order to electrically contact the semiconductor body (1) in the region of the functional portion (11).

7. Method according to any one of the preceding claims,
- wherein the trenches (2) are filled with an electrically conductive material (20) electrically isolated from the semiconductor body (1) by an insulation layer (21) applied on surfaces of the trenches (2).

8. Method according to claim 7, wherein
- the semiconductor device (100) is an insulated gate transistor,
- the trench (2) is part of the insulated gate.

9. Method according to any one of the preceding claims, wherein
- the semiconductor body (1) comprises at least one further functional portion (11a) laterally arranged between two trenches (2) and spaced from the functional portion (11) by at least one trench (2),
- a maximum width of the further functional portion (11a) is smaller than a maximum width of the functional portion (11).

10. Method according to claim 9, wherein
- implanting the first-type dopants and/or the second-type dopants is done with such an implant angle α that the further functional portion (11a) is completely shaded by a first section (31) of the mask (31).

11. Semiconductor device (100) comprising
- a semiconductor body (1) having a top side (10),
- at least one first and one second trench (2) each extending from the top side (10) into the semiconductor body (1) and being laterally spaced from each other, wherein
- a functional portion (11) of the semiconductor body (1) is arranged laterally between the first and the second trench (2),
- a first region (12) of the functional portion (11) is of a first conductivity type, the first region (12) adjoining the top side (10), being arranged adjacent to the first trench (2) and being laterally spaced from the second trench (2),
- a second region (13) of the functional portion (11) is of a second conductivity type, the second region (13) adjoining the top side (1), being arranged adjacent to the second trench (2) and being laterally spaced from the first trench (2).

12. Semiconductor device (100) according to claim 11, wherein
- the maximum width of the functional portion (11) measured in lateral direction is at most 1.0 µm.

13. Semiconductor device (100) according to claim 11 or 12, wherein
- a remnant structure of a mask (3) is on the top side (10) and overlaps with the at least one trench (2) in plan view of the top side (10).

14. Semiconductor device (100) according to claim 13, wherein
- the remnant structure of the mask (3) is a Si-structure.

15. Semiconductor device (100) according to any one of claims 11 to 14, wherein
- the trenches (2) are filled with an electrically conductive material (20) which is electrically isolated from the semiconductor body (1) by an insulation layer (21) applied on surfaces of the trenches (2),
- a main electrode (5) on the top side (11) is in electrical contact with the functional portion (11),
- a gate electrode (6) on the top side (12) is in electrical contact with the electrically conductive material (20) in at least the first trench (2).
